(19) Europäisches Patentamt
European Patent Office
Office européen des brevets

(11) EP 2 128 191 B1

(12) EUROPEAN PATENT SPECIFICATION

(45) Date of publication and mention of the grant of the patent:
**18.01.2017 Bulletin 2017/03**

(51) Int Cl.:
***C08J 7/00*** $^{(2006.01)}$ ***H05B 33/08*** $^{(2006.01)}$

(21) Application number: **09007226.5**

(22) Date of filing: **29.05.2009**

(54) **Barrier laminate, gas barrier film, device, and method for producing barrier laminate**

Sperrschichtlaminat, Gassperrfolie, Vorrichtung und Verfahren zur Herstellung des Sperrschichtlaminats

Stratifié barrière, film à barrière contre les gaz, dispositif et procédé de production du stratifié barrière

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **30.05.2008 JP 2008142631**

(43) Date of publication of application:
**02.12.2009 Bulletin 2009/49**

(73) Proprietor: **FUJIFILM Corporation**
**Tokyo 106-8620 (JP)**

(72) Inventors:
- **Ito, Shigehide**
**Ashigarakami-gun**
**Kanagawa 258-8577 (JP)**
- **Tsukahara, Jiro**
**Ashigarakami-gun**
**Kanagawa 258-8577 (JP)**

(74) Representative: **Hoffmann Eitle**
**Patent- und Rechtsanwälte PartmbB**
**Arabellastraße 30**
**81925 München (DE)**

(56) References cited:
**EP-A- 0 475 628**
**WO-A-2008/112452**
**US-A1- 2006 093 758**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### TECHNICAL FIELD

The invention relates to a barrier laminate, a gas barrier film, and a device using them. The invention also relates to a method for producing the barrier laminate.

### BACKGROUND ART

Heretofore various films having barrier property have been studied and developed. For example, JP-A 08-165368 discloses a transparent conductive film having an organic layer comprising a bisphenol A epoxy acrylate resin.

Further, JP-A 2004-299230 discloses a gas barrier film having a smoothening layer comprising a cardo polymer on a substrate. US 2006/0093758 A1 describes that the smoothening layer is formed of a cardo polymer, solgel, or a material containing an acryl structure.

However, there is an increased demand for a gas barrier film having higher gas barrier property in recent years.

### SUMMARY OF THE INVENTION

The invention is to solve the above-mentioned problems and to provide a gas barrier film having higher barrier property.

Given the situation as above, the present inventors have assiduously studied and, as a result, have found that gas barrier property can be improved by employing a polymerizable composition comprising a tri- or more-functional (meth)acrylate having a cyclic carbon structure for a material of an organic layer. Specifically the above-mentioned problems can be solved by the invention, as defined in the claims.

According to the invention, a gas barrier film having high barrier property can be provided. Since an organic layer of the gas barrier film of the invention has a smoother surface, a smooth inorganic layer can be laminated on the organic layer. As a result, the smoothness of the outermost surface of the gas barrier film can be improved, and the performance of devices provided on the gas barrier film can be improved.

### DETAILED DESCRIPTION OF THE INVENTION

The contents of the invention are described in detail herein under. In this description, the numerical range expressed by the wording "a number to another number" means the range that fails between the former number indicating the lowermost limit of the range and the latter number indicating the uppermost limit thereof. The organic EL device as referred to in the invention means an organic electroluminescent device. In this description, (meth)acylate means both acrylate and methacrylate. The expression "tri- or more-functional (meth)acrylate" denotes a compound having three or more (meth)acryloyloxy groups.

<Barrier Laminate>

The barrier laminate of the invention is characterized in that it comprises at least one organic layer and at least one inorganic layer laminated thereon, and the organic layer is formed by curing a polymerizable composition comprising a (meth)acrylate having a cyclic carbon structure and having three or more (meth)acryloyoxy groups, represented by formula (I) as defined below. The organic layer imparts higher barrier property to the barrier laminate of the invention.

The barrier laminate of the invention preferably has an alternately laminated structure of at least two organic layers and at least two inorganic layers.

(Organic Layer)

The organic layer in the invention is formed by curing a polymerizable composition comprising a tri- or more-functional (meth)acrylate having a cyclic carbon structure.

(Cyclic Carbon Rate in Polymerizable Monomers)

The polymerizable composition used in the invention has a cyclic carbon rate in polymerizable monomers of preferably 20% or more, more preferably 25% to 50%. By employing the preferable range, highly smooth surface and high barrier property can be attained more easily after lamination of the inorganic layer. The cyclic carbon rate in polymerizable monomers is obtained by the following equation (A):

$$X/Y \times 100 \quad (A)$$

wherein X represents the total weight of the carbon atoms constituting the cyclic carbon structures in the polymerizable monomers comprised in the composition, and Y represents the total weight of the polymerizable monomers comprised in the composition.

(Tri- or more-Functional (Meth)acrylate having a Cyclic Carbon Structure)

The tri- or more-functional (meth)acrylate having a cyclic carbon structure has an aromatic ring structure as the cyclic carbon structure.

The tri- or more-functional (meth)acrylate having a cyclic carbon structure used in the invention is preferably a tri- or tetra-functional (meth)acrylate.

The molecular weight of the tri- or more-functional (meth)acrylate having a cyclic carbon structure used in the invention is preferably 450 to 1000.

The polymerizable composition used in the invention may comprise two or more kind of tri- or more-functional (meth)acrylates having a cyclic carbon structure.

The tri- or more-functional (meth)acrylate having a cyclic carbon structure is represented by the following formula (1):

Formula (1)

$(R^3)_m$, $R^2$, $(R^4)_n$, $R^1$

$R^1$ and $R^2$ each represent a hydrogen atom, or a substituted or unsubstituted alkyl or a substituted or unsubstituted aryl group, and $R^1$ and $R^2$ may be taken together to form a ring. $R^1$ and $R^2$ each represent a hydrogen atom, an alkyl group or an aryl group, and these groups are all preferable. A methyl group is particularly preferable as the alkyl group, and a phenyl group is particularly preferable as the aryl group. When both $R^1$ and $R^2$ are an alkyl group and are taken together to form a ring, 1,1-cyclohexylidene group is particularly preferable. When at least one of $R^1$ or $R^2$ is an aryl group, an aryl group having one or more acryloyl or methacryloyl groups as substituents are particularly preferable.

$R^1$ and $R^2$ may have a substituent. Examples of the substituent include an alkyl group (for example, methyl group, ethyl group, isopropyl group, tert-butyl group, n-octyl group, n-decyl group, n-hexadecyl group, cyclopropyl group, cyclopentyl group, and cyclohexyl group), an alkenyl group (for example, vinyl group, allyl group, 2-butenyl group and 3-pentenyl group), an aryl group (for example, phenyl group, p-methylphenyl group, naphthyl group, anthryl group, phenanthryl group and pyrenyl group), halogen atoms (for example, fluorine atom, chlorine atom, bromine atom and iodine atom), an acyl group (for example, acetyl group, benzoyl group, formyl group and pivaloyl group), an acyloxy group (for example, acetoxy group, acryloyloxy group and methacryloyloxy group), an alkoxycarbonyl group (for example, methoxycarbonyl group and ethoxycarbonyl group), an aryloxycarbonyl group (for example, phenyloxycarbonyl group), a sulfonyl group (for example, methanesulfonyl group and benzenesulfonyl group.), a sulfinyl group (for example, methanesulfinyl group and benzenesulfinyl group), a hetero ring group (preferably having 1 to 12 carbon atoms; preferably having nitrogen atom, oxygen atom, sulfur atom, etc. as a hetero atom; may be an aliphatic hetero ring or an aromatic hetero ring; for example, imidazolyl group, pyridyl group, quinolyl group, furyl group, thienyl group, piperidyl group, morpholino group, benzoxazolyl group, benzoimidazolyl group, benzothiazolyl group, carbazolyl group and azepinyl group). Those substituents may be substituted further.

$R^3$ and $R^4$ each represent a substituent.

Examples of $R^3$ and $R^4$ include the same substituents as exemplified for $R^1$ and $R^2$ above. Among them, a group having a substituent include acryloyloxy group or methacryloyloxy group is particularly preferable. Examples for such substituent include acryloyloxy group, methacryloyloxy group, 2-acryloyloxyethoxy group, 2-methacryloyloxyethoxy group, 2-hydroxy-3-acryloyloxypropoxy group, 2-hydroxy-3-methacryloyloxypropoxy group, 2-octanoyloxy-3-acryloyloxypropoxy group, 2-heptanoyloxy-3-methacryloyloxypropoxy group, 2,3-bis(acryloyloxy)propoxy group, and 2,3-bis(methacryloyloxy)propoxy group.

m and n each indicate an integer of from 0 to 5; and when m is 2 or more, $R^3$ may be the same or different; and when n is 2 or more, $R^4$ may be the same or different. $R^1$, $R^2$, $R^3$ and $R^4$ may each include an acryloyloxy group or a methacryloyloxy group. The total number of acryloyloxy group and methacryloyloxy group in the compound represented by the formula (1) is at least 3. Particularly preferable total number of acryloyloxy group and methacryloyloxy group in the compound represented by the formula (1) is 3 or 4.

Specific examples of the tri- or more-functional (meth)acrylate having a cyclic carbon structure are shown below, to which, however, the invention should not be limited.

n=1,3,4,5,8,10

n=1,3,4,5,8,10

n=1,2

n=1,2

(Bi-Functional (Meth)acrylate)

The polymerizable composition used in the invention preferably comprises a bi-functional (meth)acrylate. Barrier property and surface smoothness of the organic layer can be more improved by employing the bi-functional (meth)acrylate. Preferable examples of the bi-functional (meth)acrylate include ethylene glycol di(meth)acrylate, propylene glycol di(meth)acrylate, butylene glycol di(meth)acrylate, neopentyl glycol di(meth)acrylate, hexanediol di(meth)acrylate.

Specific examples of the bi-functional (meth)acrylate are shown below, to which, however, the invention should not be limited.

n=4,6,9,10,12,14,16

n=4,6,9,10,12,14,16

n=2,3,4,5

n=2,3,4,5

The bi-functional (meth)acrylate is preferably mixed with the tri- or more-functional (meth)acrylate having a cyclic carbon structure so that the produced mixture can have a cyclic carbon rate in polymerizable monomers of preferably 20% or more, more preferably 25% to 50%. By employing the preferable range, more smooth surface and high barrier property after lamination of an inorganic layer can be attained more easily. The polymerizable composition used in the invention may comprise two or more kind of the bi-functional (meth)acrylates.

The polymerizable composition used in the invention may comprise other monomers. Example of the monomers include a tri- or more-functional (meth)acrylate not having cyclic carbon structure.

$CH_2=CHC(=O)O-CH_2CF_3$

$CH_2=CHC(=O)O-CH_2Cl_3$

(Other Monomers, Polymer)

The polymerizable composition used in the invention may include monomers other than (meth)acrylate (for example, styrene derivative, maleic anhydride derivative, epoxy compound, oxetane derivative) and various polymers (for example, polyester, methacrylic acid-maleic acid copolymer, polystyrene, transparent fluoro-resin, polyimide, fluorinated polyimide, polyamide, polyamide imide, polyether imide, cellulose acylate, polyurethane, polyether ketone, polycarbonate, alicyclic polyolefin, polyarylate, polyether sulfone, polysulfone, fluorene modified polycarbonate, alicyclic modified polycarbonate, fluorene modified polyester).

(Polymerization Initiator)

The polymerizable composition in the invention may include a polymerization initiator. When a photopolymerization initiator is used, its amount is preferably at least 0.1 mol% of the total amount of the polymerizable compound, more preferably from 0.5 to 2 mol%. By setting the thus-designed composition, polymerization reaction though an active ingredient forming reaction may be suitably controlled. Examples of the photopolymerization initiator include Ciba Speciality Chemicals' commercial products, Irgacure series (e.g., Irgacure 651, Irgacure 754, Irgacure 184, Irgacure 2959,

Irgacure 907, Irgacure 369, Irgacure 379, Irgacure 819), Darocure series (e.g., Darocure TPO, Darocure 1173), Quantacure PDO; Lamberti's commercial products, Ezacure series (e.g., Ezacure TZM, Ezacure TZT, Ezacure KTO46) and oligomer-type Esacure KIP series, etc.

(Method of formation of organic layer)

The method for forming the organic layer is not specifically defined. For example, the layer may be formed according to known coating methods such as a solution coating method and a vacuum film formation method. The solution coating method is, for example, a dipping method, an air knife coating method, a curtain coating method, a roller coating method, a wire bar coating method, a gravure coating method, a slide coating method, or an extrusion coating method using a hopper as in USP 2681294. The vacuum film formation method is not specifically defined, but is preferably a film formation method by vapor deposition or plasma CVD. In the invention, the polymer may be applied for coating as its solution, or a hybrid coating method along with an inorganic material, as in JP-A 2000-323273 and 2004-25732, may also be used.

In the invention, the polymerizable composition is exposed to light for curing, and the light for exposure is generally a UV ray from a high-pressure mercury lamp or low-pressure mercury lamp. The radiation energy is preferably at least 0.1 $J/cm^2$, more preferably at least 0.5 $J/cm^2$. Acrylate and methacrylate may suffer from interference in polymerization owing to oxygen in air, and therefore, in their polymerization, the oxygen concentration or the oxygen partial pressure is preferably lowered. When the oxygen concentration in polymerization is lowered according to a nitrogen purging method, the oxygen concentration is preferably at most 2%, more preferably at most 0.5%. When the oxygen partial pressure in polymerization is lowered by a pressure reduction method, the whole pressure is preferably at most 1000 Pa, more preferably at most 100 Pa. Especially preferred is UV polymerization with at least 0.5 $J/cm^2$ energy radiation under a condition of reduced pressure of at most 100 Pa.

The organic layer is preferably smooth and having a hard surface. The mean surface roughness (Ra) in 1 $\mu m^2$ of the organic layer is preferably less than 1 nm, more preferably less than 0.5 nm. Preferably, the rate of polymerization of monomer is at least 85%, more preferably at least 88%, even more preferably at least 90%, still more preferably at least 92%. The rate of polymerization as referred to herein means the ratio of the reacted polymerizable group to all the polymerizable group (acryloyl group and methacryloyl group) in the monomer mixture. The rate of polymerization may be quantitatively determined according to IR absorptiometry.

The thickness of the organic layer is not specifically defined. However, when the layer is too thin, then its thickness could hardly keep uniformity; but when too thick, the layer may be cracked by external force applied thereto and its barrier-property may lower. From these viewpoints, the thickness of the organic layer is preferably from 50 nm to 2000 nm, more preferably from 200 nm to 1500 nm.

As so mentioned in the above, the organic layer is preferably smooth. The surface of the organic layer is required not to have impurities and projections such as particles. Accordingly, it is desirable that the organic layer is formed in a clean room. The degree of cleanness is preferably at most class 10000, more preferably at most class 1000.

Preferably, the hardness of the organic layer is higher. It is known that, when the hardness of the organic layer is high, then the inorganic layer may be formed smoothly and, as a result, the barrier level of the gas barrier film is thereby improved. The hardness of the organic layer may be expressed as a microhardness based on a nano-indentation method. The microhardness of the organic layer is preferably at least 100 N/mm, more preferably at least 150 N/mm.

Two or more organic layers may be laminated. In this case, each layer may have the same composition or may have different compositions. When two or more organic layers are laminated, they are preferably so designed that each organic layer could fall within the above-mentioned preferred range. As so mentioned in the above, the organic layer may be included as a layer have a composition continuously changing in the direction of the layer thickness with no definite interface between an organic layer and an inorganic layer, as illustrated in US-A 2004-46497.

(Inorganic Layer)

The inorganic layer is, in general, a layer of a thin film formed of a metal compound. For forming the inorganic layer, employable is any method capable of producing the intended thin film. For it, for example, suitable are physical vapor deposition (PVD) such as vapor evaporation process, sputtering process, ion plating process; various chemical vapor deposition (CVD); liquid phase growth process such as plating or sol-gel process. In the invention, when the inorganic layer is formed by a sputtering process, the produced barrier laminate also has high barrier property. Not specifically defined, the component to be in the inorganic layer may be any one satisfies the above-mentioned requirements. Examples of the components include metal oxides, metal nitrides, metal carbides, metal oxinitrides and metal oxicabides. Preferred are oxides, nitrides, carbides, oxinitrides or oxicarbides comprising at least one metal selected from Si, Al, In, Sn, Zn, Ti, Cu, Ce and Ta. Of those, preferred are oxides, nitrides or oxinitrides of a metal selected from Si, Al, In, Sn, Zn and Ti; more preferred are metal oxides, nitrides or oxinitrides with Si or Al. These may comprise any

other element as a subsidiary component. This invention is particularly significant in that when a metal oxide is selected as a component of the inorganic layer and the inorganic layer is formed by a plasma process, the produced barrier laminate also has high barrier property.

Preferably, the surface smoothness of the inorganic layer formed in the invention is less than 1 nm in terms of the mean surface roughness (Ra value) in 1 μm square, more preferably at most 0.3 nm. It is desirable that the inorganic layer is formed in a clean room. Preferably, the degree of cleanness is at most class 10000, more preferably at most class 1000.

Not specifically defined, the thickness of the inorganic layer is generally within a range of from 5 to 500 nm/layer, preferably within a range of from 10 to 200 nm/layer. Two or more inorganic sublayers may be laminated. In this case, the constitutive layers may have the same composition or may have different compositions. The boundary between the organic layer and the inorganic layer may be unclear and the composition may continuously change in the thickness direction as shown in US 2004/46497.

(Lamination of Organic Layer and Inorganic Layer)

The organic layer and the inorganic layer may be laminated by repeated film formation to form the organic layer and the inorganic layer in a desired layer constitution. When the inorganic layer is formed according to a vacuum film formation process such as sputtering process, vacuum evaporation process, ion plating process or plasma CVD, then it is desirable that the organic layer is also formed according to a vacuum film formation process such as the above-mentioned flash vapor deposition process. While the barrier layer is formed, it is especially desirable that the organic layer and the inorganic layer are laminated all the time in a vacuum of at most 1000 Pa, not restoring the pressure to an atmospheric pressure during the film formation. More preferably, the pressure is at most 100 Pa, even more preferably at most 50 Pa, still more preferably at most 20 Pa.

Particularly, the barrier laminate of the invention shows improved barrier property when it has an alternately laminated structure of at least two organic layers and at least two inorganic layers. For example, an organic layer, an inorganic layer, an organic layer and an inorganic layer can be laminated on a substrate in this order; and an inorganic layer, an organic layer, an inorganic layer and an organic layer can be laminated on a substrate in this order.

The number of the layers constituting the barrier laminate is not specifically limited. Typically, 2 to 30 layers are preferable and 3 to 20 layers are more preferable. The barrier laminate of the invention may have a layer other than the organic layer and inorganic layer.

The barrier laminate of the invention may comprise a gradation material layer where the composition is continuously changed from one of an organic region and an inorganic region to the other in the thickness direction of the layer. As examples of the gradation material, there are mentioned materials described in Kim et al's report, Journal of Vacuum Science and Technology A, Vol. 23 pp. 971-977 (2005 American Vacuum Society); and gradation layers of an organic layer and an inorganic layer laminated with no boundary therebetween as in US 2004-46497.

(Functional Layer)

The barrier laminate of the invention may have a functional layer on the barrier laminate or in any other position. The functional layer is described in detail in JP-A 2006-289627, paragraphs 0036 to 0038. Examples of other functional layers than those are a matting agent layer, a protective layer, a solvent-resistant layer, an antistatic layer, a smoothening layer, an adhesiveness improving layer, a light shielding layer, an antireflection layer, a hard coat layer, a stress relaxing layer, an antifogging layer, an anti-soiling layer, a printable layer, an adhesive layer, etc.

(Use of Barrier Laminate)

In general, the barrier laminate of the invention is formed on a support. Selecting the support, the barrier laminate may have various applications. The support includes a substrate film, as well as various devices, optical members, etc. Concretely, the barrier laminate of the invention may be used as a barrier layer of a gas barrier film. The barrier laminate and the gas barrier film of the invention may be used for sealing up devices that require gas barrier performance. The barrier laminate and the gas barrier film of the invention may apply optical members. These are described in detail hereinunder.

<Gas Barrier Film>

The gas barrier film comprises a substrate film and a barrier laminate formed on the substrate film. In the gas barrier film, the barrier laminate of the invention may be provided only one surface of the substrate film, or may be provided on both surfaces thereof. The barrier laminate of the invention may be laminated in an order of an inorganic

layer and an organic layer from the side of the substrate film; or may be laminated in an order of an organic layer and an inorganic layer from it. The uppermost layer of the laminate of the invention may be an inorganic layer or an organic layer.

The gas barrier film of the invention is a film substrate having a barrier layer that functions to block oxygen, water, nitrogen oxide, sulfur oxide, ozone and others in air.

Not specifically defined, the number of the layers that constitute the gas barrier film may be typically from 2 layers to 30 layers, more preferably from 3 layers to 20 layers.

The gas barrier film may have any other constitutive components (e.g., functional layers such as adhesive layer) in addition to the barrier laminate and the substrate film. The functional layer may be disposed on the barrier laminate, or between the barrier laminate and the substrate film, or on the side (back) of the substrate film not coated with the barrier laminate.

(Plastic Film)

In the gas barrier film of the invention, the substrate film is generally a plastic film. Not specifically defined in point of the material and the thickness thereof, the plastic film usable herein may be any one capable of supporting a laminate of an organic layer and an inorganic layer; and it may be suitably selected depending on the use and the object thereof. Concretely, the plastic film includes thermoplastic resins such as polyester resin, methacryl resin, methacrylic acid-maleic anhydride copolymer, polystyrene resin, transparent fluororesin, polyimide, fluoropolyimide resin, polyamide resin, polyamidimide resin, polyetherimide resin, cellulose acylate resin, polyurethane resin, polyether ether ketone resin, polycarbonate resin, alicyclic polyolefin resin, polyarylate resin, polyether sulfone resin, polysulfone resin, cycloolefin copolymer, fluorene ring-modified polycarbonate resin, alicyclic-modified polycarbonate resin, fluorene ring-modified polyester resin, acryloyl compound.

When the gas barrier film of the invention is used as a substrate of a device such as an organic EL device to be mentioned hereinunder, it is desirable that the plastic film is formed of a heat-resistant material. Concretely, the plastic film is preferably formed of a heat-resistant transparent material having a glass transition temperature (Tg) of not lower than 100°C and/or a linear thermal expansion coefficient of at least 40 ppm/°C. Tg and the linear expansion coefficient may be controlled by the additives to the material. The thermoplastic resin of the type includes, for example, polyethylene naphthalate (PEN: 120°C), polycarbonate (PC: 140°C), alicyclic polyolefin (e.g., Nippon Zeon's Zeonoa 1600: 160°C), polyarylate (PAr: 210°C), polyether sulfone (PES: 220°C), polysulfone (PSF: 190°C), cycloolefin copolymer (COC, compound described in JP-A 2001-150584: 162°C), polyimide (Mitsubishi gas chemical company's Neopulim : 260 °C), fluorene ring-modified polycarbonate (BCF-PC, compound described in JP-A 2000-227603: 225°C), alicyclic-modified polycarbonate (IP-PC, compound described in JP-A 2000-227603: 205°C), acryloyl compound (compound described in JP-A 2002-80616: 300°C or more) (the parenthesized data are Tg). In particular, for high transparency, use of alicyclic polyolefin is preferred.

When the gas barrier film of the invention is used in devices such as organic EL devices, the plastic film is transparent, or that is, its light transmittance is generally at least 80%, preferably at least 85%, more preferably at least 90%. The light transmittance may be measured according to the method described in JIS-K7105. Concretely, using an integrating sphere-type light transmittance meter, a whole light transmittance and a quantity of scattered light are measured, and the diffusive transmittance is subtracted from the whole transmittance to obtain the intended light transmittance of the sample.

Even when the gas barrier film of the invention is used in displays, it does not always require transparency in a case where it is not disposed on the viewers' side. Accordingly in such a case, a nontransparent material may be used for the plastic film. The nontransparent material includes, for example, polyimide, polyacrylonitrile, known liquid-crystal polymer.

Not specifically defined, the thickness of the plastic film for use in the gas barrier film of the invention may be suitably selected depending on its use. Typically, the thickness may be from 1 to 800 μm, preferably from 10 to 200 μm. The plastic film may have a functional layer such as a transparent conductive layer, a primer layer, etc. The functional layer is described in detail in JP-A 2006-289627, paragraphs 0036 to 0038. Examples of other functional layers than those are a matting agent layer, a protective layer, a solvent-resistant layer, an antistatic layer, a planarizing layer, an adhesiveness improving layer, a light shielding layer, an antireflection layer, a hard coat layer, a stress relaxing layer, an antifogging layer, an anti-soiling layer, a printable layer, an adhesive layer, etc. <Device>

The barrier laminate and the gas barrier film of the invention are favorably used for devices that are deteriorated by the chemical components in air (e.g., oxygen, water, nitrogen oxide, sulfur oxide, ozone). Examples of the devices are, for example, organic EL devices, liquid-crystal display devices, thin-film transistors, touch panels, electronic papers, solar cells, other electronic devices. More preferred are organic EL devices.

The barrier laminate of the invention may be used for film-sealing of devices. Specifically, this is a method of providing a barrier laminate of the invention on the surface of a device serving as a support by itself. Before providing

the barrier laminate, the device may be covered with a protective layer.

The gas barrier film of the invention may be used as a substrate of a device or as a film for sealing up according to a solid sealing method. The solid sealing method comprises forming a protective layer on a device, then forming an adhesive layer and a gas barrier film as laminated thereon, and curing it. Not specifically defined, the adhesive may be a thermosetting epoxy resin, a photocurable acrylate resin, etc.

(Organic EL Device)

Examples of an organic EL device with a gas barrier film are described in detail in JP-A 2007-30387.

(Liquid-Crystal Display Device)

A reflection-type liquid-crystal display device has a constitution of a lower substrate, a reflection electrode, a lower alignment film, a liquid-crystal layer, an upper alignment film, a transparent electrode, an upper substrate, a λ/4 plate and a polarizing film, formed in that order from the bottom. In this, the gas barrier film of the invention may be used as the transparent electrode substrate and the upper substrate. In color displays, it is desirable that a color filter layer is additionally provided between the reflection electrode and the lower alignment film, or between the upper alignment film and the transparent electrode. A transmission-type liquid-crystal display device has a constitution of a backlight, a polarizer, a λ/4 plate, a lower transparent electrode, a lower alignment film, a liquid-crystal layer, an upper alignment film, an upper transparent electrode, an upper substrate, a λ/4 plate and a polarizing film, formed in that order from the bottom. In this, the substrate of the invention may be sued as the upper transparent electrode and the upper substrate. In color displays, it is desirable that a color filter layer is additionally provided between the lower transparent electrode and the lower alignment film, or between the upper alignment film and the transparent electrode. Not specifically defined, the type of the liquid-crystal cell is preferably a TN (twisted nematic) type, an STN (super-twisted nematic) type, a HAN (hybrid aligned nematic) type, a VA (vertically alignment) type, an ECB (electrically controlled birefringence) type, an OCB (optically compensatory bent) type, a CPA (continuous pinwheel alignment) type, or an IPS (in-plane switching) type.

The gas barrier film of the invention can also be used in combination with a polarizing plate, and it is preferable that the gas barrier layer surface of the gas barrier film is faced at the inside of a cell and is disposed' in the innermost (adjacent to the device). At that time, since the gas barrier film is disposed in the inside of the cell relative to the polarizing plate, a retardation value of the gas barrier film is important. As to a use form of the gas barrier film in such an embodiment, it is preferable that a gas barrier film using a base material film having a retardation value of not more than 10 nm and a circular polarizing plate ((λ/4 plate) + (half-wave plate) + (linear polarizing plate)) are laminated and used, or that a linear polarizing plate is combined with a gas barrier film using a base material film having a retardation value of from 100 nm to 180 nm, which can be used as a λ/4 plate, and used.

Examples of the base material film having a retardation of not more than 10 nm include cellulose triacetate (FUJITAC, manufactured by Fujifilm Corporation), polycarbonates (PURE-ACE, manufactured by Teijin Chemicals Ltd.; and ELMECH, manufactured by Kaneka Corporation), cycloolefin polymers (ARTON, manufactured by JSR Corporation; and ZEONOR, manufactured by Zeon Corporation), cycloolefin copolymers (APEL (pellet), manufactured by Mitsui Chemicals, Inc.; and TOPAS (pellet), manufactured by Polyplastics Co., Ltd.), polyarylates (U100 (pellet), manufactured by Unitika Ltd.) and transparent polyimides (NEOPULIM, manufactured by Mitsubishi Gas Chemical Company).

Also, films obtained by stretching the above film so as to have a desired retardation value can be used as a λ/4 plate.

(Solar Cell)

The gas barrier film of the invention can be used also as a sealing film for solar cell devices. Preferably, the gas barrier film of the invention is used for sealing a solar cell device in such a manner that its adhesive layer is on the side near to the solar cell device. The solar cell devices for which the gas barrier film of the invention is favorably used are not specifically defined. For example, they include single crystal silicon-based solar cell devices, polycrystalline silicon-based solar cell devices, single-junction or tandem-structure amorphous silicon-based solar cell devices, gallium-arsenic (GaAs), indium-phosphorus (InP) or the like III-V Group compound semiconductor-based solar cell devices, cadmium-tellurium (CdTe) or the like II-VI Group compound semiconductor-based solar cell devices, copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices, dye-sensitized solar cell devices, organic solar cell devices, etc. Above all, in the invention, the solar cell devices are preferably copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices.

<Electronic paper>

The gas barrier film of the invention can be used in an electronic paper. The electronic paper is a reflection-type electronic display capable of attaining a high precision and a high contrast.

The electronic paper has a display media and a TFT driving the display media on a substrate. Any known display media can be used in the electronic paper. For example, any display media of electophoretic-type, electopowder flight-type, charged tonner-type, electrochromic type can be preferably used. Among them, electophoretic display media is more preferable and microcapsule-type electophoretic display media is particularly preferable. The electophoretic display media has a plural number of capsules and each capsule has at least one particle capable of moving in a suspension flow. The at least one particle is preferably an electrophoretic particle or a spinning ball. The electrophretic display media has a first plane and a second plane that are placed in parallel, and an image is displayed through one of the two planes.

A TFT formed on a substrate comprises a gate electrode, gate insulating layer, an active layer, a source electrode and a drain electrode. A TFT also comprises a resistance layer between the active layer and the source electrode and/or between the active layer and the drain electrode to attain electric connection.

When a color display with a high precision is produced, TFT's are preferably formed on a color filter to precisely align them. Normal TFT with a low electric efficiency can not be down-sized much while obtaining the necessary driving current, and when a high precision display is pursued, the rate of the area for the TFT in a pixel must be high. When the rate of the area for the TFT is high, the rate of the opening area and contrast are low. Even when a transparent amorphous IGZO-type TFT is used, light transmittance is not 100% and reduction of contrast is unavoidable. Use of the TFT disclosed in JP-A 2009-21554 and the like can reduce the rate of the TFT in a pixel and improve the rate of the opening area and contrast. High precision can also be attained by forming this type of TFT on a color filter directly.

(Others)

Other applications of the invention are thin-film transistors as in JP-T H10-512104, and touch panels as in JP-A 5-127822, 2002-48913.

<Optical Member>

An example of the optical member that comprises the barrier laminate of the invention is a circular polarizer.

(Circular Polarizer)

Laminating a gas barrier film of the invention with a $\lambda/4$ plate and a polarizer gives a circular polarizer. In this case, the components are so laminated that the slow axis of the $\lambda/4$ plate could cross the absorption axis of the polarizer at an angle of 45°. The polarizer is preferably stretched in the direction of 45° from the machine direction (MD) thereof; and for example, those described in JP-A 2002-865554 are favorably used.

EXAMPLES

The characteristics of the invention are described more concretely with reference to the following Examples. In the following Examples, the material used, its amount and the ratio, the details of the treatment and the treatment process may be suitably modified or changed. Accordingly, the invention should not be limitatively interpreted by the Examples mentioned below.

<Production and Evaluation of Gas Barrier Films>

A composition comprising a polymerizable compound shown in the following Table (the total amount is 15 weight parts) and the polymerization initiator (Chiba Speciality Chemicals, IRGACURE907) (the amount is 1 weight part) was prepared using methyl ethyl ketone (the amount is 185 weight parts). The composition was coated on a polyethylene naphthalate film (manufactured by Teijin DuPont, Teonex Q65FA, having a thickness of 100 $\mu$m) to form a film "having a dry film thickness of 500 nm, and then cured through irradiation with UV rays at a dose of 0.5 J/cm$^2$ in atmosphere having 100 ppm of oxygen, thereby producing an organic layer. Aluminum oxide was deposited on the surface of the formed organic layer according to a vacuum sputtering (a radical sputtering) to form a layer having thickness of 30 nm, thereby producing a gas barrier film. The obtained gas barrier film was tested and evaluated for the water vapor permeability and the mean surface roughness (Ra) according to the test methods below. In Example 6, the polymerization initiator (Lamberti, KTO46) was used in place of the above polymerization initiator (Chiba Speciality Chemicals,

IRGACURE907).[Water Vapor Permeability (g/m$^2$/day)]

The water vapor permeability was measured according to the method described in G. NISATO, P.C.P. BOUTEN, P.J. SLIKKERVEER, et al.; SID Conference Record of the International Display Research Conference 1435-1438. The water vapor permeability (g/m$^2$/day) was measured at 40°C and 90% relative humidity (RH). The measured water vapor permeability (g/m$^2$/day) was evaluated by the following gauge and the results were shown in below Table 1.

(Evaluation)

× :At least 0.005 g/m$^2$/day.
○ :At least 0.001 g/m$^2$/day and less than 0.005 g/m$^2$/day.
◎ :Less than 0.001 g/m$^2$/day.

[Mean Surface Roughness (Ra)]

The mean surface roughness in 1 μm$^2$ of the gas barrier film was measured by the Atomic Force Microscope (AFM). The measured mean surface roughness was evaluated by the following gauge and the results were shown in below Table 1.

(Evaluation)

× :At least 1 nm and less than 3 nm.
○ :At least 0.5 nm and less than 1 nm.
◎ :Less than 0.5 nm.

Table 1

| | Organic Layer | | | | Cyclic Carbon Rate in Rate polymerizable monomers (%) | Barrier Property | Ra |
|---|---|---|---|---|---|---|---|
| | Polymerizable Compound 1 | | Polymerizable Compound 2 | | | | |
| | Type | Amount | Type | Amount | | | |
| Example 1 | A | 100 | - | - | 29.5 | ○ | ○ |
| Example 2 | A | 80 | E | 20 | 26.7 | ◎ | ◎ |
| Example 3 | A | 50 | E | 50 | 20.9 | ○ | ○ |
| Example 4 | B | 100 | - | - | 31.3 | ○ | ○ |
| Example 5 | B | 80 | E | 20 | 28.2 | ◎ | ◎ |
| Example 6 | B | 80 | E | 20 | 28.2 | ◎ | ◎ |
| Comparative Example 1 | C | 100 | - | - | 29.7 | × | × |
| Comparative Example 2 | D | 100 | - | - | 0 | × | × |
| Comparative Example 3 | E | 100 | - | - | 0 | × | × |

In Table 1, the amounts of polymerizable compound 1 and polymerizable compound 2 are expressed as relative molar ratio, and the cyclic carbon rates in polymerizable monomers were obtained by the equation (A) above.

The structures of the polymerizable compounds used in Table 1 are shown below.

Compound A:

Compound B:

Compound C:

Compound D:

Compound E:

As is clearly shown in Table 1 above, the gas barrier films of the invention exhibited high barrier property and excellent surface smoothness. The barrier property and surface smoothness were further improved by addition of the bi-functional acrylate.

<Production and Evaluation of Organic EL Device>

In order to evaluate gas barrier property, an organic EL device in which vapor or oxygen causes dark spot was formed. An ITO film-having conductive glass substrate (surface resistivity, 10 Ω/square) was washed with 2-propanol, and then processed for UV ozone treatment for 10 minutes. On the substrate (anode), the following compound layers were formed in order by vapor deposition according to a vacuum vapor deposition process.

(First Hole Transporting Layer)

Copper phthalocyanine: film thickness 10 nm.

(Second Hole Transporting Layer)

N,N'-diphenyl-N,N'-dinaphthylbenzidine: film thickness 40 nm.

(Light-Emitting Layer also serving as electron transporting layer)

Tris(8-hydroxyquinolinato)aluminium: film thickness 60 nm.

(Electron Injection Layer)

Lithium fluoride: film thickness 1 nm.

Metal aluminium was formed on it through vapor deposition to form a cathode having a thickness of 100 nm, and a silicon nitride film having a thickness of 3 μm was formed thereon according to a parallel plate CVD, thereby constructing an organic EL device.

Next, using a thermosetting adhesive (Epotec 310, by Daizo-Nichimori), each gas barrier film formed in the above formation process and the organic EL device were stuck together in such a manner that the side of the barrier film substrate laminated with barrier layer could be on the side of the organic EL device, and heated at 65°C for 3 hours to cure the adhesive. 20 test pieces of every sample of the thus-sealed organic EL device were prepared.

Just after produced, the organic EL device was tested for light emission under application of 7 V thereto, using a source measure unit (SMU2400 Model by Keithley). Using a microscope, the light-emitting surface was observed, which confirmed uniform light emission by every device with no dark spot.

Finally, the devices were stored in a dark room at 60°C and 90% relative humidity (RH) for 24 hours, and then tested for light emission. The proportion of the test pieces that gave dark spots larger than 300 μm in diameter is defined as a failure rate. The failure rate of every sample was computed. All the inventive samples were preferable with a failure rate of at most 5%.

<Production of Electronic paper>

An electronic paper was produced by using the gas barrier film each of Examples 2 and 5 as a substrate.

On the gas barrier film of Example 2 or 5, ITO of 30 nm thick was deposited as a gate electrode, SiON of 500 nm thick was deposited thereon as a gate insulating layer, IGZO of 10 nm thick was laminated as an active layer by a RF magnetron-spattering vacuum vapor deposition process (target: sintered polycrystalline material having a composition of $InGaZnO_4$, Ar flow: 12 sccm, $O_2$ flow: 0.2 sccm, RF power: 200W, pressure: 0.4 Pa), and IGZO of 40 nm thick was laminated as a resistance layer by the same condition as the active layer except that $O_2$ flow was changed to 1.5 sccm. ITO's of 40 nm thick were formed on the active layer as a source electrode and a drain electrode to obtain a TFT film.

Separately, electrophoretic display media was formed on a polyethylene naphthalate (PEN) film (5 inch x 5 inch) as a second substrate by the process disclosed in the Example of JP-T 2002-511606 to obtain a electrophoretic film.

The TFT film and the electrophoretic film were laminated so that the source/drain electrode of the TFT film could face the upper electrode of the electophoretic film. The TFT film and the electrophoretic film were electrically isolated with each other, and the drain electrode and the upper electrode of the electrophretic film were electrically connected through the contact hole on the drain electrode to obtain an electronic paper.

INDUSTRIAL APPLICABILITY

Since the gas barrier film of the invention has high barrier property, it can be widely used for various devices that are required to have barrier property. In the gas barrier film of the invention, the organic layer has improved smoothness and therefore a smooth inorganic layer can also be formed. This improvement makes it possible to improve smoothness of the outermost surface of the gas barrier film and performance of devices provided on the gas barrier film. Furthermore, it is quite significant that the gas barrier film of the invention also exhibits high barrier property when it is formed by a plasma process.

**Claims**

**1.** A barrier laminate comprising at least one organic layer and at least one inorganic layer, wherein the inorganic layer is laminated on the organic layer, and wherein the organic layer is formed by curing a polymerizable composition comprising a (meth)acrylate having a cyclic carbon structure and having three or more (meth)acryloyloxy groups, represented by formula (1):

$$(R^3)_m \quad R^2 \quad (R^4)_n \quad R^1 \qquad (1)$$

wherein $R^1$ and $R^2$ each are H or an optionally substituted alkyl or aryl group, and $R^1$ and $R^2$ may be taken together to form a ring; $R^3$ and $R^4$ each are a substituent; m and n each indicate an integer of 0-5; when m is $\geq 2$ the $R^3$ groups may be the same or different, and when n is $\geq 2$ the $R^4$ groups may be the same or different; with the proviso that the total number of (meth)acryloyloxy groups in the compound (1) is at least 3.

**2.** The barrier laminate of claim 1, wherein the polymerizable composition has a cyclic carbon rate in polymerizable monomers, calculated as $[(X/Y)\times 100]\%$, wherein X is the total weight of carbon atoms constituting cyclic carbon structures in the polymerizable monomers comprised in the composition, and Y is the total weight of the polymerizable monomers comprised in the composition, of 20% or more.

**3.** The barrier laminate of claim 1 or 2, wherein the polymerizable composition further comprises a (meth)acrylate having two (meth)acryloyloxy groups.

**4.** The barrier laminate of any of claims 1-3, wherein the inorganic layer comprises a metal oxide.

**5.** The barrier laminate of any of claims 1-4, wherein at least two organic layers and at least two inorganic layers are laminated alternately.

**6.** A gas barrier film comprising a support and, provided thereon, a barrier laminate as defined in any of claims 1-5.

**7.** A device comprising the gas barrier film of claim 6.

**8.** The device of claim 7, comprising the gas barrier film as a substrate thereof.

**9.** The device of claim 7, sealed with the gas barrier film of claim 6 or the barrier laminate of any of claims 1-5.

**10.** The device of any of claims 7-9, which is an electronic device or an organic EL device.

**11.** A method for producing the barrier laminate of any of claims 1-5, comprising the steps of

(i) curing a polymerizable composition comprising a (meth)acrylate having a cyclic carbon structure and having three or more (meth)acryloyloxy groups to form the organic layer, wherein the (meth)acrylate is represented by formula (1):

$$(R^3)_m\text{-}C_6H_{5-m}\text{-}C(R^1)(R^2)\text{-}C_6H_{5-n}\text{-}(R^4)_n \quad (1)$$

wherein $R^1$ and $R^2$ each are H or an optionally substituted alkyl or aryl group, and $R^1$ and $R^2$ may be taken together to form a ring; $R^3$ and $R^4$ each are a substituent; m and n each indicate an integer of 0-5; when m is $\geq 2$ the $R^3$ groups may be the same or different, and when n is $\geq 2$ the $R^4$ groups may be the same or different; with the proviso that the total number of (meth)acryloyloxy groups in the compound (1) is at least 3; and
(ii) forming the inorganic layer before or after forming the organic layer.

**12.** The method of claim 11, wherein the inorganic layer is formed by a sputtering process.

**13.** The method of claim 11, wherein the inorganic layer is formed by a plasma process.

**Patentansprüche**

**1.** Sperrlaminat, umfassend zumindest eine organische Schicht und zumindest eine anorganische Schicht, worin die anorganische Schicht auf der organischen Schicht laminiert ist und worin die organische Schicht durch Härten einer polymerisierbaren Zusammensetzung gebildet ist, enthaltend ein (Meth)acrylat mit einer cyclischen Kohlenstoffstruktur und mit drei oder mehr (Meth)acryloyloxygruppen, dargestellt durch die Formel (1) :

$$(R^3)_m\text{-}C_6H_{5-m}\text{-}C(R^1)(R^2)\text{-}C_6H_{5-n}\text{-}(R^4)_n \quad (1)$$

worin $R^1$ und $R^2$ jeweils H oder eine wahlweise substituierte Alkyl- oder Arylgruppe sind und $R^1$ und $R^2$ zusammen einen Ring bilden können, $R^3$ und $R^4$ jeweils ein Substituent sind, m und n jeweils eine ganze Zahl von 0 bis 5 anzeigen, worin dann, wenn $m \geq 2$ ist, die Gruppen $R^3$ gleich oder verschieden sein können und wenn $n \geq 2$ ist, die Gruppen $R^4$ gleich oder verschieden sein können, mit dem Vorbehalt, dass die Gesamtzahl der (Meth)acryloyloxygruppen in der Verbindung (1) zumindest 3 ist.

**2.** Sperrlaminat nach Anspruch 1, worin die polymerisierbare Zusammensetzung eine cyclische Kohlenstoffrate in polymerisierbaren Monomeren, berechnet als $[(X/Y)\times 100]$%, worin X das Gesamtgewicht der Kohlenstoffatome ist, die die cyclischen Kohlenstoffstrukturen in den polymerisierbaren Monomeren, die in der Zusammensetzung enthalten sind, ausmachen, und Y das Gesamtgewicht der polymerisierbaren Monomere, die in der Zusammensetzung enthalten sind, ist, von 20% oder mehr hat.

**3.** Sperrlaminat nach Anspruch 1 oder 2, worin die polymerisierbare Zusammensetzung weiterhin ein (Meth)acrylat mit zwei (Meth)acryloyloxygruppen enthält.

**4.** Sperrlaminat nach einem der Ansprüche 1 bis 3, worin die anorganische Schicht ein Metalloxid enthält.

**5.** Sperrlaminat nach einem der Ansprüche 1 bis 4, worin zumindest zwei organische Schichten und zumindest zwei anorganische Schichten alternierend laminiert sind.

**6.** Gassperrfilm, enthaltend einen Träger, der darauf vorgesehen ein Sperrlaminat wie in einem der Ansprüche 1 bis 5 definiert enthält.

**7.** Vorrichtung, enthaltend den Gassperrfilm gemäß Anspruch 6.

**8.** Vorrichtung nach Anspruch 7, enthaltend den Gassperrfilm als Substrat davon.

**9.** Vorrichtung nach Anspruch 7, abgedichtet mit dem Gassperrfilm nach Anspruch 6 oder dem Sperrlaminat nach einem der Ansprüche 1 bis 5.

**10.** Vorrichtung nach einem der Ansprüche 7 bis 9, die eine elektronische Vorrichtung oder organische EL-Vorrichtung ist.

**11.** Verfahren zur Erzeugung des Sperrlaminates nach einem der Ansprüche 1 bis 5, enthaltend folgende Schritte:

(i) Härten einer polymerisierbaren Zusammensetzung, enthaltend ein (Meth)acrylat mit einer cyclischen Kohlenstoffstruktur und mit drei oder mehr (Meth)acryloyloxygruppen, dargestellt durch die Formel (1), zur Bildung der organischen Schicht:

$$(R^3)_m\text{-}C_6H_{5-m}\text{-}C(R^1)(R^2)\text{-}C_6H_{5-n}\text{-}(R^4)_n \qquad (1)$$

worin $R^1$ und $R^2$ jeweils H oder eine wahlweise substituierte Alkyl- oder Arylgruppe sind und $R^1$ und $R^2$ zusammen einen Ring bilden können, $R^3$ und $R^4$ jeweils ein Substituent sind, m und n jeweils eine ganze Zahl von 0 bis 5 anzeigen, worin dann, wenn $m \geq 2$ ist, die Gruppen $R^3$ gleich oder verschieden sein können und wenn $n \geq 2$ ist, die Gruppen $R^4$ gleich oder verschieden sein können, mit dem Vorbehalt, dass die Gesamtzahl der (Meth)acryloyloxygruppen in der Verbindung (1) zumindest 3 ist, und
(ii) Bilden der anorganischen Schicht vor oder nach Bilden der organischen Schicht.

**12.** Verfahren nach Anspruch 11, worin die anorganische Schicht durch ein Sputterverfahren gebildet wird.

**13.** Verfahren nach Anspruch 11, worin die anorganische Schicht durch einen Plasmavorgang gebildet wird.

**Revendications**

**1.** Stratifié barrière comprenant au moins une couche organique et au moins une couche inorganique, dans lequel la couche inorganique est stratifiée sur la couche organique, et dans lequel la couche organique est formée par durcissement d'une composition pouvant être polymérisée comprenant un (méth)acrylate ayant une structure de carbone cyclique et ayant trois groupes (méth)acryloyloxy ou plus, représenté par la formule (1) :

$$(R^3)_m\text{-}C_6H_{5-m}\text{-}C(R^1)(R^2)\text{-}C_6H_{5-n}\text{-}(R^4)_n \qquad (1)$$

dans laquelle $R^1$ et $R^2$ sont chacun H ou un groupe alkyle ou aryle substitué de manière facultative, et $R^1$ et $R^2$ peuvent être pris ensemble pour former un cycle ; $R^3$ et $R^4$ sont chacun un substituant; m et n indiquent chacun un entier de 0 à 5 ; quand m est $\geq 2$, les groupes $R^3$ peuvent être les mêmes ou différents, et lorsque n est $\geq 2$, les groupes $R^4$ peuvent être les mêmes ou différents ; avec la clause restrictive que le nombre total de groupes (méth)acryloyloxy dans le composé (1) est au moins 3.

**2.** Stratifié barrière selon la revendication 1, dans lequel la composition pouvant être polymérisée a un taux de carbone cyclique dans des monomères pouvant être polymérisés calculé par $[(X/Y) \times 100]$ %, dans lequel X est le poids total d'atomes de carbone constituant des structures de carbone cycliques dans les monomères pouvant être polymérisés compris dans la composition, et Y est le poids total des monomères pouvant être polymérisés compris dans la composition, de 20 % ou plus.

3. Stratifié barrière selon la revendication 1 ou 2, dans lequel la composition pouvant être polymérisée comprend en outre un (méth)acrylate ayant deux groupes (méth)acryloyloxy.

4. Stratifié barrière selon l'une quelconque des revendications 1 à 3, dans lequel la couche inorganique comprend un oxyde de métal.

5. Stratifié barrière selon l'une quelconque des revendications 1 à 4, dans lequel au moins deux couches organiques et au moins deux couches inorganiques sont stratifiées en alternance.

6. Film formant barrière contre les gaz comprenant un support et, disposé dessus, un stratifié barrière tel que défini dans l'une quelconque des revendications 1 à 5.

7. Dispositif comprenant le film formant barrière contre les gaz selon la revendication 6.

8. Dispositif selon la revendication 7, comprenant le film formant barrière contre les gaz en tant que substrat de ce dernier.

9. Dispositif selon la revendication 7, scellé avec le film formant barrière contre les gaz selon la revendication 6 ou le stratifié barrière selon l'une quelconque des revendications 1 à 5.

10. Dispositif selon l'une quelconque des revendications 7 à 9, qui est un dispositif électronique ou un dispositif EL organique.

11. Procédé pour produire le stratifié barrière selon l'une quelconque des revendications 1 à 5, comprenant les étapes consistant à

(i) durcir une composition pouvant être polymérisée comprenant un (méth)acrylate ayant une structure de carbone cyclique et ayant trois groupes (méth)acryloyloxy ou plus pour former la couche organique, dans lequel le (méth)acrylate est représenté par la formule (1) :

$$(R^3)_m\text{-}C_6H_{5-m}\text{-}C(R^1)(R^2)\text{-}C_6H_{5-n}\text{-}(R^4)_n \quad (1)$$

dans laquelle $R^1$ et $R^2$ sont chacun H ou un groupe aryle ou alkyle substitué de manière facultative, et $R^1$ et $R^2$ peuvent être pris ensemble pour former un cycle ; $R^3$ et $R^4$ sont chacun un substituant ; m et n indiquent chacun un entier de 0 à 5 ; lorsque m est $\geq 2$, les groupes $R^3$ peuvent être les mêmes ou différents, et lorsque n est $\geq 2$, les groupes $R^4$ peuvent être les mêmes ou différents; avec la clause restrictive que le nombre total de groupes (méth)acryloyloxy dans le composé (1) est au moins 3 ; et
(ii) former la couche inorganique avant ou après formation de la couche organique.

12. Procédé selon la revendication 11, dans lequel la couche inorganique est formée par un processus de pulvérisation cathodique.

13. Procédé selon la revendication 11, dans lequel la couche inorganique est formée par un processus au plasma.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 8165368 A
- JP 2004299230 A
- US 20060093758 A1
- US 2681294 A
- JP 2000323273 A
- JP 2004025732 A
- US 200446497 A
- US 200446497 B
- JP 2006289627 A
- JP 2001150584 A
- JP 2000227603 A
- JP 2002080616 A
- JP 2007030387 A
- JP 2009021554 A
- JP H10512104 T
- JP 5127822 A
- JP 2002048913 A
- JP 2002865554 A
- JP 2002511606 T


### Non-patent literature cited in the description


- **KIM et al.** Journal of Vacuum Science and Technology A. American Vacuum Society, 2005, vol. 23, 971-977